# EUROPEAN PATENT APPLICATION

(11) **EP 1 675 166 A2**
(43) Date of publication of application: **28.06.2006**
(21) Application number: 05252520.1
(22) Date of filing: 22.04.2005
(51) Int. Cl.: H01L 21/322, H01L 21/205

(54) **Internally gettered heteroepitaxial semiconductor wafers and methods of manufacturing such wafers**

(30) Priority: 27.12.2004 US 639363 P; 13.04.2005 US 104544
(71) Applicant: MEMC Electronic Materials, Inc., St. Peters, Missouri 63376 (US)
(72) Inventor: Seacrist, Michael R, MEMC Electronic Materials Inc, St. Peters, Missouri 63376 (US); Wilson, Gregory M., MEMC Electronic Materials Inc., St. Peters, Missouri 63376 (US); Standley, Robert W, MEMC Electronic Materials Inc., St. Peters, Missouri 63376 (US)
(74) Representative: Smaggasgale, Gillian Helen

(57) **Abstract**

A heteroepitaxial semiconductor wafer includes a heteroepitaxial layer forming the front surface of the wafer that includes a secondary material having a different crystal structure than that of the wafer primary material. The heteroepitaxial layer is substantially free of defects. A surface layer includes the primary material and is free of the secondary material. The surface layer borders the heteroepitaxial layer. A bulk layer includes the primary material and is free of the secondary material. The bulk layer borders the surface layer and extends through the central plane. An SOI wafer and a method of making wafers is disclosed.

## Description

### Background of the Invention

The present invention relates generally to semiconductor wafers, and more particularly to internally gettered heteroepitaxial semiconductor wafers and methods of manufacturing such wafers.

Internal gettering of metal impurities by oxygen precipitates is conventionally used in semiconductor wafer manufacturing. Such gettering typically requires the steps of denuded zone formation and oxygen precipitate nucleation and growth. The precipitate growth step, among other steps, occurs during device fabrication because both device fabrication and precipitate growth require the wafer be treated at high temperatures for long time periods.

Advanced device applications have caused significant interest in wafers that include heteroepitaxial layers. In a typical silicon wafer, a heteroepitaxial layer is applied to the front surface, and the layer includes some material other than silicon. The layer can be designed to alter the crystal structure (e.g., the strain state) for a variety of desirable effects, including enhanced carrier mobility, carrier concentration, light absorption and emission. Unfortunately, the heteroepitaxial layer is damaged or degraded by exposure to high temperatures such as the temperatures required for precipitate growth. Accordingly, prior art wafers have not included both internal gettering and a heteroepitaxial layer.

### Summary of the Invention

In one aspect of the invention, a heteroepitaxial semiconductor wafer has a front surface and a back surface, a central plane midway between the front and back surfaces, and a circumferential edge joining the front and back surfaces. The wafer includes a primary material. The wafer comprises a heteroepitaxial layer forming the front surface of the wafer and includes a secondary material having a different crystal structure than that of the primary material. The heteroepitaxial layer is substantially free of defects and has a thickness of at least about 5 nanometers. A surface layer includes the primary material and is free of the secondary material. The surface layer borders the heteroepitaxial layer and extends radially to within at least 5 mm of the circumferential edge. The surface layer is substantially free of defects to a depth of at least 5 microns. A bulk layer includes the primary material and is free of the secondary material. The bulk layer borders the surface layer and extends through the central plane. The bulk layer includes oxygen precipitates having a density of at least about 1 x 10⁷ precipitates/cm³.

In another aspect, a process of manufacturing a semiconductor wafer comprises slicing the wafer from an ingot, smoothing the front and back surfaces and forming a vacancy template within the wafer by rapid thermal treatment of the wafer. The method further comprises stabilizing the vacancy template by maintaining the wafer in a temperature range between about 700°C and about 900°C for at least about 30 minutes, and growing oxygen precipitates by maintaining the wafer in a temperature range between about 900°C and about 1000°C for between about 1 to 2 hours. The method also comprises forming a heteroepitaxial layer on the front surface. The heteroepitaxial layer includes a secondary material having a different crystal structure than that of the primary material, and the heteroepitaxial layer is substantially free of defects and has a depth of at least 5 nanometers.

### Other Statements of the Invention

In still another aspect, a heteroepitaxial silicon-on-insulator (SOI) wafer having a front surface and a back surface, a central plane midway between the front and back surfaces, and a circumferential edge joining the front and back surfaces, the wafer including a primary material. The wafer comprises a heteroepitaxial layer forming the front surface of the wafer and includes a secondary material having a different crystal structure than that of the primary material. The heteroepitaxial layer is substantially free of defects and has a thickness of at least 5 nanometers. The wafer also has an insulation layer and a bulk layer which comprises a second region of the wafer below the surface layer and extending through the central plane. The bulk layer includes oxygen precipitates having a density of at least about 1 x 10⁷ precipitates/cm³.

In some embodiments, the SOI wafer may also comprise a surface layer including the primary material and is free of the secondary material. The surface layer is disposed between the insulation layer and the bulk layer and extends radially to within at least about 5 mm of the circumferential edge. The surface layer is substantially free of defects to a depth of at least 5 microns measured from adjacent the insulation layer.

Another aspect is directed to a process of manufacturing a semiconductor wafer having a front surface and a back surface, a bulk layer therebetween including oxygen precipitates having a density of at least about 1x10⁷ precipitates/cm³, and a circumferential edge joining the front and back surfaces. The wafer includes a primary material. The process comprises slicing the wafer from an ingot, smoothing the front and back surfaces and outdiffusing oxygen from the wafer to form a precipitate free layer at the front surface. The precipitate free layer extends radially to within at least about 5 mm of the circumferential edge and is substantially free of defects to a depth measured from the front surface of at least 5 microns. A heteroepitaxial layer is formed on the front surface wherein the heteroepitaxial layer includes a secondary material having a different crystal structure than that of the primary material. The heteroepitaxial layer is formed so that it is substantially free of defects and has a thickness of at least 5 nanometers.

In one embodiment, the forming step may form a heteroepitaxial layer of at least 100 nanometers. In another embodiment, the outdiffusing step may be performed by maintaining the wafer in a temperature range of about 1000°C to about 1200°C for at least 3 hours. The process may also comprise nucleating oxygen precipitates by maintaining the wafer in a temperature range between about 550°C and about 700°C for about 4 to 8 hours. The process may further comprise growing the nucleated oxygen precipitates by maintaining the wafer in a temperature range between about 900°C and about 1000°C for between about 1 to about 2 hours.

### Brief Description of the Drawings

Fig. I is a vertical section taken through the center of a wafer of one embodiment of the invention;
Fig. 2 is a flow diagram of one exemplary method of the invention for processing a semiconductor wafer;
Fig. 3 is a flow diagram of another exemplary method of the invention for processing a semiconductor wafer;
Fig. 4 is a flow diagram of an additional exemplary method of the invention for processing a semiconductor wafer;
Fig. 5 is a vertical section taken through the center of another embodiment of the invention; and
Fig. 6 is a flow diagram of an exemplary method of the invention for processing an SOI wafer.

### Detailed Description of the Preferred Embodiment

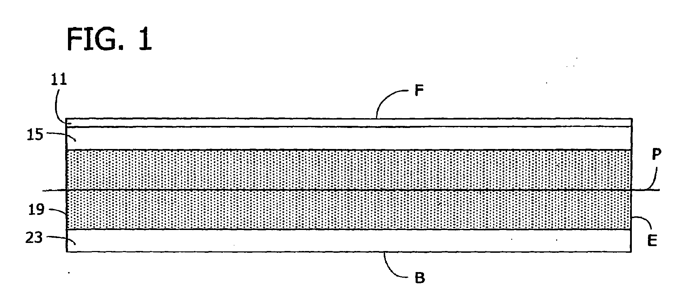

Referring now to the drawings and in particular to Fig. 1, a gettered heteroepitaxial wafer of one embodiment of the present invention is designated in its entirety by the reference numeral 11.

The wafer comprises a front surface F and a back surface B, a central plane P midway between the front and back surfaces, and a circumferential edge joining the front and back surfaces. The wafer also comprises a heteroepitaxial layer 11, an upper surface of the heteroepitaxial layer defining the front surface F. The heteroepitaxial layer has a thickness of at least about 5 nanometers, at least about 20 nanometers, at least about 100 nanometers, or even at least about 3 microns and less than about 5 microns. The heteroepitaxial layer is formed as described below so that the layer is substantially free of oxygen precipitates, meaning that any oxygen precipitates have a density of less than about 1 x 10⁶ precipitates/cm³. In other embodiments, any oxygen precipitates have a density of less than about 1 x 10⁵ precipitates/cm³, and other defects within the heteroepitaxial layer are limited to about 1 x 10⁵ defects/cm², or even about 1 x 10⁴ defects/cm².

A first surface layer 15 is disposed beneath the heteroepitaxial layer. The first surface layer extends radially substantially to the circumferential edge, i.e., to within at least about 5 mm of the circumferential edge, though it may extend to within about 2 mm of the edge or to the edge. The surface layer has a depth, measured in the direction of the central plane, of at least about 5 microns, i.e., at least about 40 microns. The surface layer of this embodiment includes a denuded zone DZ or precipitate-free zone PFZ, as further described below, so that the layer is substantially free of oxygen precipitates to a minimum depth of at least 5 microns, or at least about 10 microns, or even at least about 40 microns.

The wafer comprises a bulk layer 19 beneath the surface layer and extending through the central plane. The bulk layer includes nucleated oxygen precipitates grown to sufficient size to getter metallic impurities. The precipitates have a density of at least about 1 x 10⁷ precipitates/cm³, or even at least about 1 x 10⁸ precipitates/cm³. Typically, the precipitates have an equivalent spherical radius of about 1 to about 50 nm, in some cases about 5 to about 15 nm, or even about 8 to about 10 nm.

A second surface layer 23 beneath the bulk layer includes a lower surface that defines the back surface of the wafer. The second surface layer need not necessarily include a denuded zone or precipitate-free zone.

The bulk layer and surface layer include a primary material (e.g., silicon) and have only negligible amounts of any other materials. In contrast, the heteroepitaxial layer includes the primary material, as well as a secondary material having a different crystal structure than that of the primary material. In this example, the primary material is silicon, and the secondary material is one or more material selected from the group including germanium, carbon, or a III-V arsenide or phosphide compound, such as GaAs or InP. The heteroepitaxial layer suitably includes two sub-layers, a relaxed sub-layer including an alloy, such as Si:Ge, Si:C, or Si:Ge:C alloy, or III-V arsenide or phosphide compounds, and a strained epitaxial sub-layer such as strained Si, strained Si:Ge, strained Si:C and strained Si:Ge:C. Other materials are contemplated within the scope of the invention.

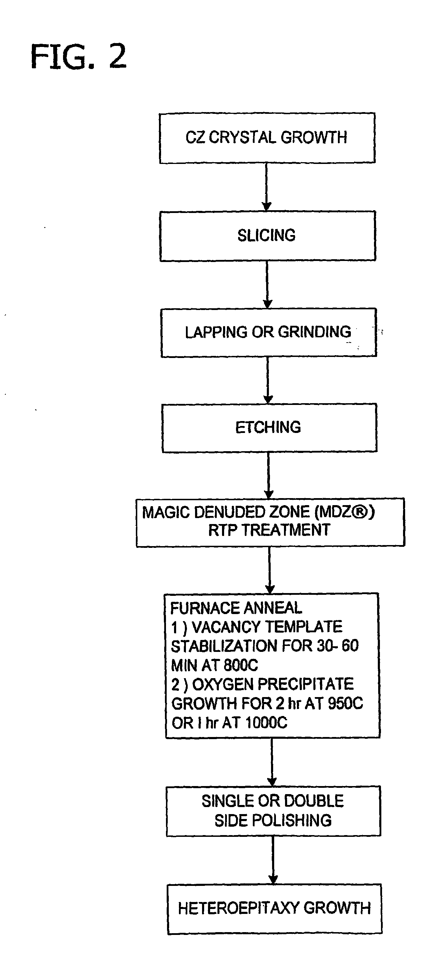

Referring to Fig. 2, the wafer is suitably manufactured by slicing the wafer from a silicon ingot, followed by lapping or grinding to flatten the surfaces and remove damage caused by slicing. The wafer is etched to further remove damage and smooth the wafer surfaces. The lapping, grinding and etching steps may be performed in any order, and may be performed according to conventional methods.

In this embodiment, a vacancy template is formed by rapid thermal processing (RTP) of the wafer. The template will catalyze subsequent oxygen cluster nucleation. Suitable RTP methods are described in co-assigned U.S. Pat. Nos. 5,994,761; 6,191,010; 6,204,152, which are incorporated herein by reference.

Oxygen precipitates, or oxygen precipitate nuclei, are then formed according to the vacancy template using a suitable annealing process. In this embodiment, the wafer is subjected to two step furnace annealing. First, the vacancy template formed during RTP is stabilized, allowing oxygen clusters to form rapidly in the vacancies. Stabilization is performed by heating the wafer and then maintaining the wafer in a temperature range between about 700°C and about 900°C for about 0.25 to about 1.5 hours, in one example by heating and maintaining the wafer at about 800°C for about 0.5 to about 1.0 hours. An exemplary anneal method is described in co-assigned U.S. Pat. App. No. 10/127,509, Pub. No. 2002/0179006, filed April 22, 2002, which is incorporated herein by reference.

In the second step of furnace annealing, the wafer is annealed to grow the oxygen precipitates. Typically, the wafer is heated and maintained at between about 900°C and about 1000°C for between about 0.5 to about 2 hours. In exemplary embodiments, the growth is accomplished by heating and maintaining the wafer at about 950°C for about 2 hours, or at about 1000°C for about 1 hour. The RTP and furnace anneal steps form a denuded zone in the surface layer that is substantially free of defects to the depth described above.

The wafer is then polished (single or double side), suitably using a conventional polishing method. This step may be performed prior to formation of the denuded zone or the furnace annealing steps.

The heteroepitaxial layer is then applied to the surface layer of the wafer so that the heteroepitaxial layer forms the front surface. The application forms the layer to a depth as described above, and may be performed according to conventional deposition processes.

The heteroepitaxial layer includes a secondary material having a different lattice constant or covalent radius (generally, crystal structure) than that of the primary material. In one embodiment, a relaxed heteroepitaxial sub-layer (e.g., a Si_{0.8}Ge_{0.2} layer), is first deposited on the surface layer, and a strained silicon epitaxial sub-layer is then applied over the relaxed layer. Many other combinations are possible. This invention contemplates designing the layer to have virtually any properties or desired effects. Conventionally, such layers alter the properties, e.g, crystal structure and strain state, for diffusion of alloy constituents, strain relief by misfit dislocation creation, layer melting or decomposition, among others. As noted above, the heteroepitaxial layer can cause desired effects, such as enhanced carrier mobility, carrier concentration, light absorption and emission.

If the heteroepitaxial layer is subjected to high temperatures, its desirable properties are usually damaged or degraded. Accordingly in this invention, high temperature treatment occurs before the layer is applied. Moreover, during device fabrication, the wafer is not subjected to high temperature treatment. In other words, after the layer is applied, the wafer is not subjected to temperatures above about 900 to 950°C for more than about 60 to 120 minutes, or higher than about 1050°C for more than about 1 to 2 minutes.

The heteroepitaxial layer is suitably grown by a conventional chemical vapor deposition (CVD) process in a single wafer reactor, such as an EPSILON® series reactor made by ASM International of Bilthoven, Netherlands or a CENTURA® series reactor made by Applied Materials of Santa Clara, CA. The layer is suitably grown so that the wafer is maintained below a temperature of about 900°C. If there is a strained silicon layer as just described, the temperature is maintained below about 700°C. As another example, the heteroepitaxial layer can be grown according to the methods described in U.S. Pat. Nos. 3,985,590 and 4,786,616, which are incorporated herein by reference.

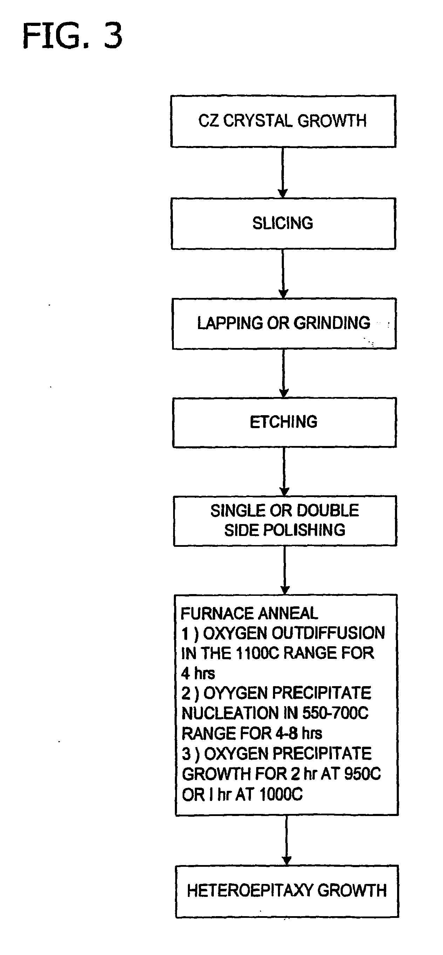

Referring to Fig. 3, in another embodiment of the method of this invention, the vacancy template/RTP step is omitted, and instead the wafer may be subjected to any of the conventional three-step furnace anneal processes, such as that described in the background section of U.S. Pat. No. 6,180,220, the entirety of the patent incorporated by reference herein. Briefly, oxygen is outdiffused from the wafer. In this embodiment, the process includes outdiffusing oxygen by heating and maintaining the wafer between about 1000° to about 1200°C for at least 3 hours, e.g., at about 1100°C for about 4 hours. Second, oxygen precipitates are nucleated by heating the wafer. In this embodiment, nucleation is performed by heating and maintaining the wafer between about 550°C and about 700°C for about 4 to 8 hours. Third, the nucleated oxygen precipitates are grown. In this embodiment, they are grown by heating and maintaining the wafer between about 900°C and about 1000°C for between about 1 to about 2 hours, e.g., about 950°C for about 2 hours, or about 1000°C for about 1 hour.

For this embodiment, the polishing step is performed before the furnace anneal, but it can be done before or after depending on the denuded zone depth and the tolerance for removal during polishing. The heteroepitaxy growth is performed after the furnace annealing.

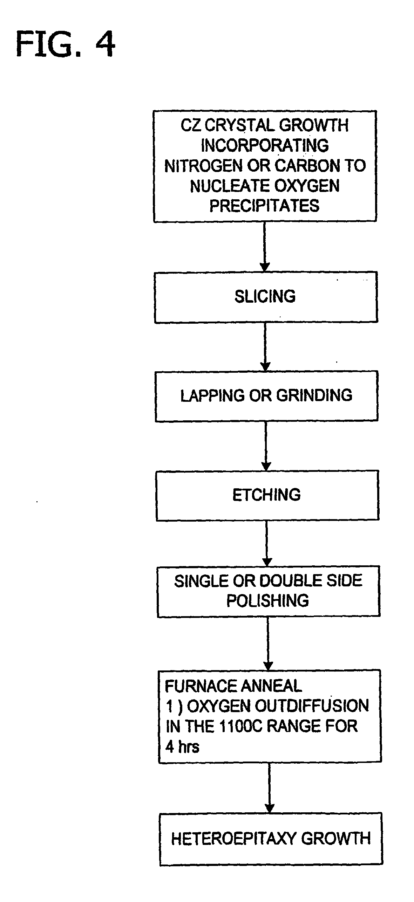

Referring to Fig. 4, in another embodiment, the wafer is sliced from an ingot having nitrogen or carbon incorporated therein for gettering. Slicing the wafer from such an ingot eliminates the need for precipitate nucleation/growth step. Accordingly, the furnace anneal process is* simply a one-step process wherein oxygen is outdiffused. In this embodiment, oxygen is outdiffused by heating and maintaining the wafer between about 1000° to about 1200°C for at least 3 hours, e.g., about 1100°C for about 4 hours.

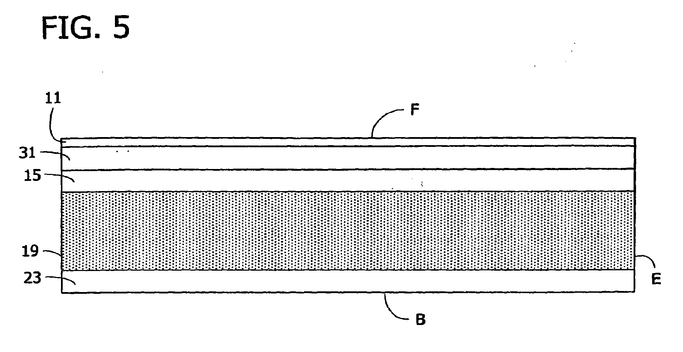

Referring to Figs. 5-6, in another embodiment, a silicon-on-insulator (SOI) wafer is substantially similar to the wafer described above, except that an insulation layer 31 is interposed between the heteroepitaxial layer 11 and the surface layer 15. In this embodiment, the insulation layer is a buried oxide layer (commonly referred to as the "box").

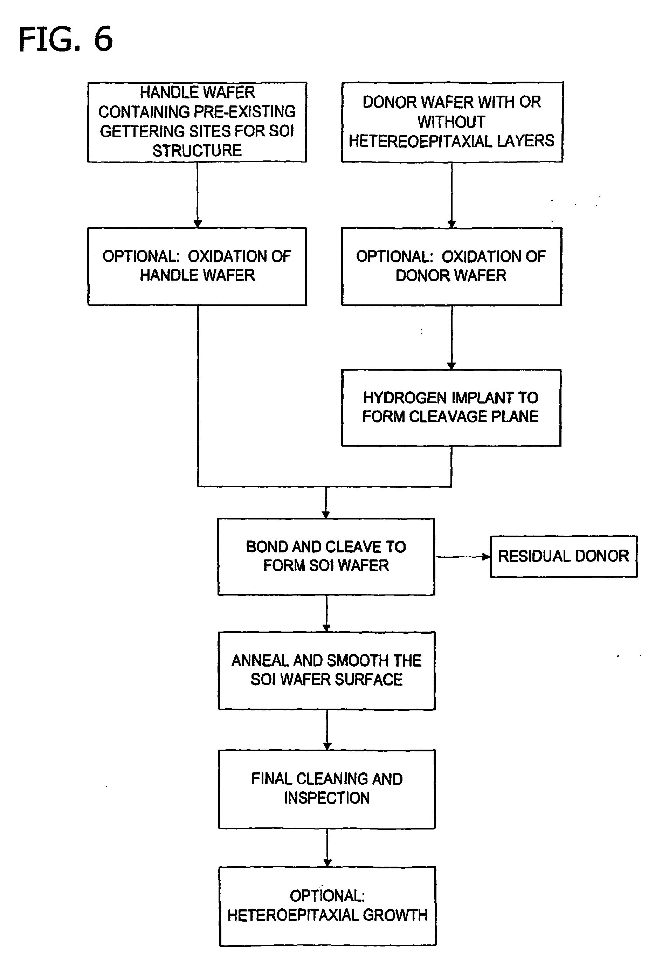

This SOI wafer is suitably manufactured according to the method shown in Fig. 6. Briefly, the handle wafer is manufactured as described above with respect to Fig. 2, though it may alternatively be manufactured according to any of the methods described above. A donor wafer is suitably manufactured with a heteroepitaxial layer, but without gettering. Alternatively, the donor wafer may be formed without a heteroepitaxial layer, in which case the layer is added as a final step in the method. Further, one sub-layer of the heteroepitaxial layer may be formed on the donor wafer, and then a second sub-layer added after subsequent steps.

One of the handle wafer and the donor wafer is subjected to an oxidation step to form an oxidation layer on its surfaces. It is also possible to form the oxidation layer on both the handle and donor wafer.

The donor wafer is then subjected to a conventional hydrogen implant step to form a cleavage plane therein. The donor and handle wafers are conventionally bonded, and the donor wafer is cleaved at the cleavage plane, resulting in a new SOI wafer and a residual donor wafer. The SOI wafer is annealed to cement the bond and to further grow the oxygen precipitates. A suitable annealing step is performed at about 1000 to about 1100°C for at least one hour, up to several hours. The wafer is then smoothed, e.g., by chemical and/or thermal smoothing, or by polishing.

Wafers manufactured according to the methods of this invention are advantageous in that they have all the desirably characteristics of a heteroepitaxial wafer, but also have gettered metallic impurities. Prior art wafers did not combine the benefits of gettered wafers with the benefits of heteroepitaxial wafers. The new wafers are ideal for producing semiconducting devices with low thermal budgets.

In view of the above, it will be seen that the several objects of the invention are achieved and other advantageous results attained.

When introducing elements of the present invention or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

As various changes could be made in the above constructions without departing from the scope of the invention, it is intended that all matter contained in the above description or shown in the accompanying drawings shall be interpreted as illustrative and not in a limiting sense.

## Claims

1. A heteroepitaxial semiconductor wafer having a front surface and a back surface, a central plane midway between the front and back surfaces, and a circumferential edge joining the front and back surfaces, the wafer including a primary material, the wafer comprising:
a heteroepitaxial layer forming the front surface of the wafer and including a secondary material having a different crystal structure than that of the primary material;
the heteroepitaxial layer being substantially free of defects and having a thickness of at least 5 nanometers;
a surface layer including the primary material and free of the secondary material, the surface layer bordering the heteroepitaxial layer and extending radially to within at least 5 mm of the circumferential edge, wherein the surface layer is substantially free of defects to a depth of at least 5 microns; and
a bulk layer including the primary material and free of the secondary material, the bulk layer bordering the surface layer and extending through the central plane, wherein the bulk layer includes oxygen precipitates having a density of at least about 1 x 10⁷ precipitates/cm³.

2. The wafer of Claim 1 wherein the primary material is silicon and the secondary material of the heteroepitaxial layer includes a strained silicon layer and a relaxed silicon-germanium layer.

3. The wafer of Claim 1 or Claim 2 wherein the heteroepitaxial layer has a thickness of at least 20 nanometers.

4. The wafer of any one of Claims 1 to 3 wherein the heteroepitaxial layer has a thickness of at least 100 nanometers.

5. The wafer of any one of Claims 1 to 4 wherein the surface layer is substantially free of defects to a depth of at least 10 microns.

6. The wafer of any one of Claims 1 to 5 wherein the bulk layer includes oxygen precipitates having a density of at least about 1 x 10⁸ precipitates/cm³.

7. A process of manufacturing a semiconductor wafer having a front surface and a back surface, a central plane midway between the front and back surfaces, a bulk layer straddling the central plane, and a circumferential edge joining the front and back surfaces, the wafer including a primary material, the process comprising:
slicing the wafer from an ingot;
smoothing the front and back surfaces;
forming a vacancy template within the wafer by rapid thermal treatment of the wafer;
stabilizing the vacancy template by maintaining the wafer in a temperature range between about 700°C and about 900°C for at least about 30 minutes;
growing oxygen precipitates by maintaining the wafer in a temperature range between about 900°C and about 1000°C for between about 1 to 2 hours;
forming a heteroepitaxial layer on the front surface,
the heteroepitaxial layer including a secondary material having a different crystal structure than that of the primary material;
the heteroepitaxial layer being substantially free of defects and having a depth of at least 5 nanometers.

8. The process of Claim 7 wherein the forming step forms a heteroepitaxial layer of at least 100 nanometers.

9. The process of Claim 7 or 8 further comprising stabilizing vacancies within the wafer by maintaining the wafer in a temperature range between about 700°C and about 900°C for about 0.25 to about 1.5 hours.

10. The process of Claim 9 further comprising growing the nucleated oxygen precipitates by maintaining the wafer in a temperature range between about 900°C and about 1000°C for between about 0.5 to about 2 hours.
